# EUROPEAN PATENT APPLICATION

(11) **EP 4 756 814 A1**
(43) Date of publication of application: **10.06.2026**
(21) Application number: 25197811.0
(22) Date of filing: 25.08.2025
(51) Int. Cl.: G11C 29/02, G11C 29/12, G11C 29/26, G11C 29/38, G11C 29/44, G11C 5/14, G11C 7/10, G11C 13/00, G11C 16/04, G11C 16/08, G11C 16/30, G11C 16/32, G11C 29/20, G11C 29/24, G11C 29/46

(54) **STORAGE DEVICE**

(30) Priority: 04.12.2024 KR 20240178469
(71) Applicant: Samsung Electronics Co., Ltd., Suwon-si, Gyeonggi-do 16677 (KR)
(72) Inventor: SHIN, Seo-Hyun, 16677 Suwon-si, Gyeonggi-do (KR); YUN, Sewon, 16677 Suwon-si, Gyeonggi-do (KR); LEE, Kyungduk, 16677 Suwon-si, Gyeonggi-do (KR)
(74) Representative: Kuhnen & Wacker Patent- und Rechtsanwaltsbüro PartG mbB

(57) **Abstract**

A storage device (10) is provided. The storage device includes a first non-volatile memory device (31) including a first current management circuit (31_1) configured to determine an execution timing of a first command based on first peak information, and output first elapsed time information indicating an internal operation time according to the first command; a second non-volatile memory device (33) including a second current management circuit (33_1) configured to determine an execution timing of a second command based on second peak information, and output second elapsed time information indicating an internal operation time according to the second command; and a storage controller (20) including a peak manager circuit (21) configured to output the first peak information and deactivate a failed current management circuit among the first and second current management circuits (31_1, 33_1) based on the first elapsed time information and the second elapsed time information.

## Description

### BACKGROUND

Recently, with the multifunctionality of information and communication devices, larger capacity and higher integration of memory devices are required. In particular, to address the demand for high integration and high performance for non-volatile memory cells, research on stacking and increased input/output speed for non-volatile memory cells is being conducted. Memory operations of non-volatile memory devices may induce a high peak current that exceeds a certain level and may seriously damage the overall performance and stability of a storage device including multiple non-volatile memory devices.

### SUMMARY

One or more embodiments provide a storage device that efficiently manages peak current periods where power consumption is concentrated.

One or more embodiments also provide a storage device that efficiently manages a peak current section in response to an abnormally operating current management circuit.

According to an aspect of an embodiment, a storage device includes: a first non-volatile memory device including a first current management circuit configured to receive a first command and first peak information in a first mode and determine an execution timing of the first command based on the first peak information, wherein the first non-volatile memory device is configured to output first elapsed time information indicating an internal operation time according to the first command; a second non-volatile memory device including a second current management circuit configured to receive a second command and the first peak information in the first mode and determine an execution timing of the second command based on the first peak information, wherein the second non-volatile memory device is configured to output second elapsed time information indicating an internal operation time according to the second command, and a storage controller including a peak manager circuit configured to output the first peak information and deactivate a failed current management circuit among the first current management circuit and the second current management circuit based on the first elapsed time information and the second elapsed time information.

According to another aspect of an embodiment, a storage controller, includes: a processor configured to output a command for instructing a memory operation to a non-volatile memory device including a plurality of memory cells, and output a dummy command for testing the performance of a current management circuit within the non-volatile memory device based on a signal representing an internal state of the non-volatile memory device; a peak manager circuit configured to output pseudo peak information indicating a peak current section based on the dummy command, receive elapsed time information indicating an internal operating time of the non-volatile memory device according to the dummy command, and determine performance of the current management circuit based on the elapsed time information; and a queue manager circuit configured to perform queue management operations for the non-volatile memory device based on the performance of the current management circuit.

According to another aspect of an embodiment, a Universal Flash Storage (UFS) system, includes: a UFS host configured to determine a power budget, and a UFS device. The UFS device includes: a plurality of non-volatile memories, wherein a non-volatile memory of the plurality of non-volatile memories includes a current management circuit configured to share peak information indicating a peak current section for a command based on the power budget and determine an execution timing of the command; and a UFS controller configured to output a dummy command for testing performance of the current management circuit and a pseudo peak signal including a predefined peak current section, control power of the current management circuit based on internal operation times of the plurality of non-volatile memories according to the dummy command and the pseudo peak signal, and perform a queue management operation on the plurality of non-volatile memories based on the internal operation times of the plurality of non-volatile memories.

### BRIEF DESCRIPTION OF DRAWINGS

The above and other aspects will be more apparent from the following description of embodiments taken in conjunction with the accompanying drawings.
FIG. 1 is a block diagram showing a storage device according to some embodiments.
FIG. 2 is a block diagram of a storage device according to some embodiments.
FIG. 3 is a diagram showing a semiconductor package according to some embodiments.
FIG. 4A is a diagram for explaining a method of operating the memory dies of FIG. 3 according to some embodiments.
FIG. 4B is a diagram for explaining an operation method of the memory dies of FIG. 3 according to some embodiments.
FIG. 5 is a block diagram of the storage controller of FIG. 1.
FIG. 6 is a block diagram of the non-volatile memory device of FIG. 1.
FIG. 7 is a circuit diagram for explaining a memory block of the memory cell array of FIG. 6.
FIG. 8 is a diagram for explaining operation of a non-volatile memory device according to some embodiments.
FIG. 9 is a timing diagram for explaining an operating method of a non-volatile memory device according to some embodiments.
FIG. 10 is a timing diagram for explaining an operating method of a non-volatile memory device according to some embodiments.
FIG. 11 is a timing diagram for explaining an operating method of a non-volatile memory device according to some embodiments.
FIG. 12 is a block diagram of a queue manager according to some embodiments.
FIG. 13 is a timing diagram for explaining an operating method of a queue manager according to some embodiments.
FIG. 14 is a diagram showing peak current values according to parameter setting values of a non-volatile memory device according to some embodiments.
FIG. 15 is a flowchart showing an operating method of a storage device according to some embodiments.
FIG. 16 is a block diagram showing a solid-state drive (SSD) system to which a storage device is applied according to some embodiments.
FIG. 17 is a block diagram illustrating a Universal Flash Storage (UFS) system according to some embodiments.

### DETAILED DESCRIPTION

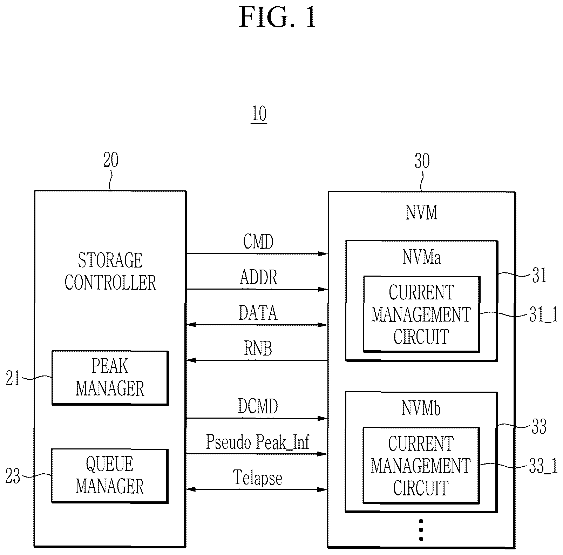

FIG. 1 is a block diagram showing a storage device according to some embodiments.

In some embodiments, the storage device 10 may include a storage controller 20 and a non-volatile memory device 30. The non-volatile memory device 30 may include a plurality of non-volatile memory devices 31, 33.

The storage controller 20 may control the overall operation of the storage device 10 and control the overall data exchange between an external device (e.g., host) and a non-volatile memory device 30. The storage controller 20 may be implemented as an integrated circuit (IC), a system on chip (SoC), an application processor (AP), a mobile AP, a chipset, or a collection of chips. As an example, the storage controller 20 may be a semiconductor device that controls a non-volatile memory device 30 to write data or read data according to a request from a host, and the storage controller 20 may also be a component included in an application processor (AP).

The storage controller 20 may transmit a command (CMD) and an address (ADDR) to a non-volatile memory device 30 according to a host request. When a non-volatile memory device 30 receives a command (CMD) and an address (ADDR) instructing to write data (DATA) from a storage controller 20, the non-volatile memory device 30 may write the corresponding data (DATA) to a memory location corresponding to the address (ADDR). Additionally, the storage controller 20 may be configured to run firmware for controlling a non-volatile memory device 30. For example, the non-volatile memory device 30 may be implemented in the form of a solid state drive (SSD), a smart SSD, an embedded Multi-Media Card (eMMC), an embedded Universal Flash Storage (UFS) memory device, a UFS memory card, a Compact Flash (CF), a Secure Digital (SD), a Micro-SD (Micro Secure Digital), a Mini-SD (Mini Secure Digital), an xD (extreme Digital), a Memory Stick, or a similar form.

In some embodiments, the non-volatile memory device 30 may generate a ready/busy signal (RNB) indicating a busy state in which an internal operation is being performed or a ready state in which the internal operation is not being performed (i.e., has been completed), and may transmit the ready/busy signal (RNB) to the storage controller 20. Specifically, the storage controller 20 may transmit a command to check the internal status of the non-volatile memory device 30, and the non-volatile memory device 30 may transmit a ready/busy signal (RNB) to the storage controller 20 in response to the command of the storage controller 20. For example, while the non-volatile memory device 30 reads data (DATA) in response to a read command of the storage controller 20 or writes data (DATA) in response to a write command of the storage controller 20, the non-volatile memory device 30 may transmit a ready/busy signal (RNB) indicating a busy state (e.g., a logic low level) to the storage controller 20. Alternatively, when internal operations of the non-volatile memory device 30 are not performed or completed, the non-volatile memory device 30 may transmit a ready/busy signal (RNB) indicating a ready state (e.g., a logic high level) to the storage controller 20. The storage controller 20 may check the internal status of the non-volatile memory device 30 through the ready/busy signal (RNB). In the present disclosure below, program (or write), read and erase operations for a non-volatile memory device 30 are referred to as memory operations.

In some embodiments, the storage controller 20 may receive a power budget allocated to the storage device 10 from the host. The host may transmit the power budget allocated to the storage device 10 to the storage controller 20, but embodiments are not limited thereto, and for example, the power budget for the storage device 10 may be provided through a Power Management Integrated Circuit (PMIC), may be determined in advance, or may be determined by the storage controller 20 within the storage device 10.

The power budget allocated to the storage device 10 may indicate the maximum power that the storage device 10 can use. Alternatively, the power budget allocated to the storage device 10 may indicate the maximum current or maximum voltage allowable by the non-volatile memory device 30 within the storage device 10. When non-volatile memory devices 30 in a storage device 10 operate simultaneously and exceed the maximum current or maximum power, it is difficult to ensure normal operation of the storage device 10.

In some embodiments, each of the plurality of non-volatile memory devices 31, 33 in non-volatile memory 30 may include current management circuits 31_1, 33_1. The current management circuits 31_1, 33_1 according to some embodiments may generate peak information associated with a command CMD that is received from a storage controller 20. For example, the current management circuits 31_1, 33_1 may the generate peak information in response to the command CMD. Here, the peak information associated with the command CMD may include information about a peak current section, which is a section in which power consumption of a plurality of non-volatile memory devices 31, 33 is concentrated in response to the command CMD. The current management circuits 31_1, 33_1 may transmit peak information to at least some of the plurality of non-volatile memory devices 31, 33 within the non-volatile memory device 30, or receive peak information generated from at least some of the plurality of non-volatile memory devices 31, 33.

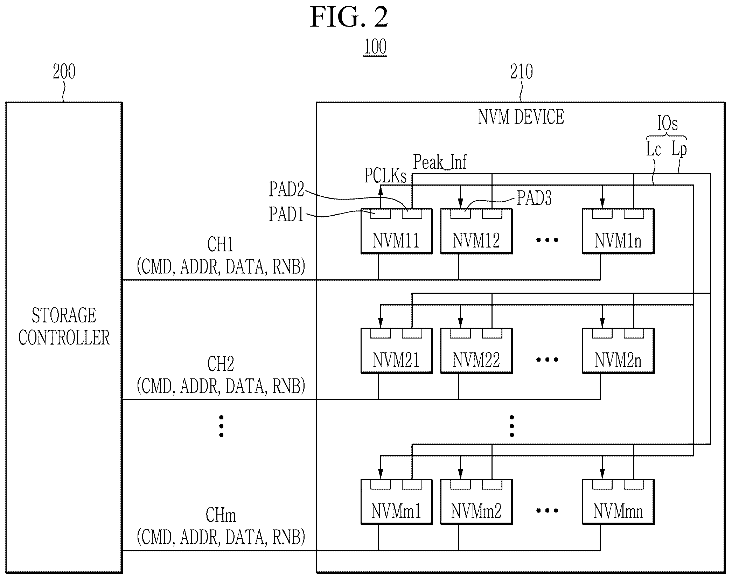

In some embodiments, current management circuits 31_1, 33_1 may determine a command execution timing based on the peak information. The current management circuits 31_1, 33_1 may control the command execution timing based on the peak information so that peak current sections of the plurality of non-volatile memory devices 31, 33 do not overlap, and may manage the power consumed by the storage device 10 below the power budget. A detailed description of the current management circuits 31_1, 33_1 will be described later with reference to FIG. 2 to FIG. 4.

Some of the current management circuits 31_1, 33_1 may operate abnormally. For example, some of the current management circuits 31_1, 33_1 may output incorrect information about the peak current section as peak information. Or, some of the current management circuits 31_1, 33_1 may not control the command execution timing even though the peak current sections overlap and the power consumed by the storage device 10 exceeds the power budget. Alternatively, some of the current management circuits 31_1, 33_1 may delay the command execution timing even though the peak current sections do not overlap. These abnormal operations may result in deterioration of the storage device 10. Therefore, the storage device 10 needs to detect abnormal operation of the current management circuits 31_1, 33_1 and respond to the abnormal operation of the current management circuits 31_1, 33_1. Hereinafter, an abnormally operating current management circuit (i.e., ones of the current management circuits 31_1, 33_1 that is abnormally operating) is referred to as a failed (or abnormal) current management circuit.

In some embodiments, the storage controller 20 may include a peak manager(or peak manager circuit) 21 and a queue manager 23. The storage controller 20 may enter a test mode to find a failed current management circuit. Specifically, the storage controller 20 may generate a dummy command DCMD to find a failed current management circuit and transmit the dummy command DCMD to a plurality of non-volatile memory devices 31, 33. In some embodiments, the peak manager 21 may generate pseudo peak information (Pseudo Peak_Inf) and output the pseudo peak information (Pseudo Peak_Inf) to a plurality of non-volatile memory devices 31, 33 together with or subsequent to the dummy command DCMD. The peak manager 21 may output pseudo peak information (Pseudo Peak_Inf) of logic high level during the peak current section. The length of the peak current section may be determined in advance. However, embodiments are not limited thereto, and the peak manager 21 may output pseudo peak information (Pseudo Peak_Inf) of logic low level during the peak current section. The peak manager 21 may output pseudo peak information (Pseudo Peak_Inf) to the plurality of non-volatile memory devices 31, 33, so that the current management circuits 31_1, 33_1 control the execution timing of dummy command DCMD. The peak manager 21 may output pseudo peak information Pseudo Peak_Inf to the plurality of non-volatile memory devices 31, 33 so that the current management circuits 31_1, 33_1 queue the dummy command DCMD in a command queue based on the peak current section of the pseudo peak information Pseudo Peak_Inf and execute the dummy command DCMD when the peak current section of the pseudo peak information (Pseudo Peak_Inf) ends.

In some embodiments, the plurality of non-volatile memory devices 31, 33 may not generate peak information regarding the dummy command DCMD in the test mode or may not share peak information regarding the dummy command DCMD. In some embodiments, a plurality of non-volatile memory devices 31, 33 may output elapsed time information Telapse to the storage controller 20 in response to a dummy command DCMD and pseudo peak information (Pseudo Peak_Inf). Here, the elapsed time information Telapse may include information about the peak current section within the pseudo peak information (Pseudo Peak_Inf) and information about the actual internal operation time of the plurality of non-volatile memory devices 31, 33 by the dummy command DCMD. In some embodiments, the peak manager 21 may obtain the internal operation times of the plurality of non-volatile memory devices 31, 33 by a dummy command DCMD from elapsed time information Telapse and determine the failed current management circuit from the internal operation times. For example, the peak manager 21 may power off or disable the failed current management circuit.

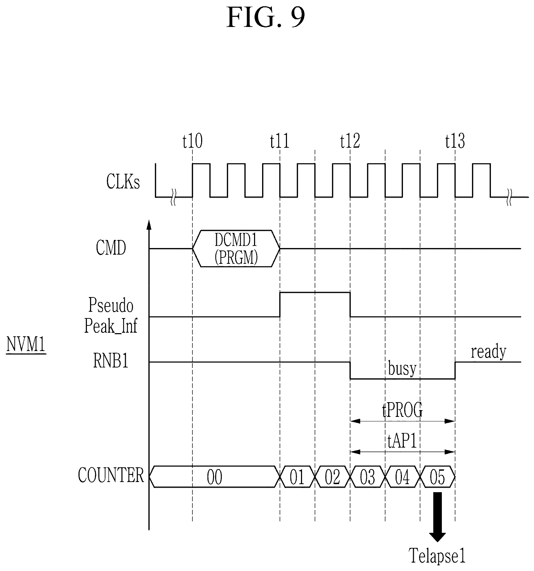

In some embodiments, the queue manager 23 may perform the queue management operation for the non-volatile memory device including the failed current management circuit. Specifically, the queue manager 23 may determine a command to be transmitted to the non-volatile memory device including the failed current management circuit, or determine the timing to transmit a command to the non-volatile memory device including the failed current management circuit. Alternatively, the queue manager 23 may change the setting values of the operating parameters of the non-volatile memory device including the failed current management circuit. A specific description of the peak manager 21 and the queue manager 23 will be described later with reference to FIG. 9 to FIG. 14.

FIG. 2 is a block diagram of a storage device according to some embodiments. A storage device 100 according to some embodiments may correspond to the storage device 10 of FIG. 1.

Referring to FIG. 2, a non-volatile memory device 210 and a storage controller 200 may be connected through a plurality of channels CH1, CH2, ..., CHm. For example, the storage device 100 may be implemented as a storage device such as a Solid State Drive (SSD). The non-volatile memory device 210 may include a plurality of non-volatile memory devices NVM11, NVM12, ..., NVMmn. A plurality of non-volatile memory devices NVM11, NVM12, ..., NVMmn may correspond to a plurality of non-volatile memory devices 31, 33 of FIG. 1. Each of the plurality of non-volatile memory devices NVM11, NVM12, ..., NVMmn may be connected to the storage controller 200 through the plurality of channels CH1, CH2, ..., CHm. In some embodiments, each of the non-volatile memory devices NVM11, NVM12, ..., NVMmn may be implemented as any memory unit that may operate according to individual commands from the storage controller 200. For example, each of the non-volatile memory devices NVM11, NVM12, ..., NVMmn may be a memory die, and thus the storage device 100 may be a packaged chip including a plurality of dies, but embodiments are not limited thereto, and for example, each of the non-volatile memory devices NVM11, NVM12, ..., NVMmn may be a memory in a single packaged chip.

The storage controller 200 may control a non-volatile memory device 210 through multiple channels CH1, CH2, ..., CHm. For example, the storage controller 200 may transmit a command CMD, an address ADDR, and data DATA to the non-volatile memory device 210 or receive data DATA from the non-volatile memory device 210 through the plurality of channels CH1, CH2, ..., CHm. Additionally, the storage controller 200 may receive a ready/busy signal RNB from the non-volatile memory device 210 through the plurality of channels CH1, CH2, ..., CHm.

In some embodiments, the plurality of non-volatile memory devices NVM11, NVM12, ..., NVMmn may include a plurality of pads PAD1, PAD2, PAD3. The plurality of non-volatile memory devices NVM11, NVM12, ..., NVMmn may transmit and receive shared clock signals PCLKs and peak information Peak_Inf through shared input/output lines IOs connected to the plurality of pads PAD1, PAD2, PAD3.

In some embodiments, the plurality of non-volatile memory devices NVM11, NVM12, ..., NVMmn may share a shared clock signal PCLKs through a shared clock line Lc of a shared input/output line IOs. Additionally, the plurality of non-volatile memory devices NVM11, NVM12, ..., NVMmn may transmit and receive peak information Peak_Inf through shared data lines Lp of shared input/output lines IOs. Specifically, a first non-volatile memory device NVM11 among the plurality of non-volatile memory devices NVM11, NVM12, ..., NVMmn may output a shared clock signal PCLKs to a shared clock line Lc. In some embodiments, the first non-volatile memory device NVM11 among the plurality of non-volatile memory devices NVM11, NVM12, ..., NVMmn may operate as a master device and output the shared clock signal PCLKs. A plurality of current management circuits (current management circuits 31_1, 33_1 in FIG. 1) within a plurality of non-volatile memory devices NVM11, NVM12, ..., NVMmn may generate peak information Peak_Inf associated with a command CMD in response to receiving a command CMD from a storage controller 200 and transmit the peak information Peak_Inf to another non-volatile memory device through a shared data line Lp in synchronization with a specific cycle of a shared clock signal PCLKs. For example, the first non-volatile memory device NVM11 may transmit peak information Peak_Inf to another non-volatile memory devices NVM12, ..., NVMmn through the shared data line Lp in synchronization with a specific cycle of the shared clock signal PCLKs. The first non-volatile memory device NVM11 may receive peak information Peak_Inf from another non-volatile memory devices NVM12, ..., NVMmn that is output in synchronization with a specific cycle of a shared clock signal PCLKs. In some embodiments, each of the plurality of pads PAD1, PAD2, PAD3 may be a transmit-only pad, a receive-only pad, or a transmit/receive combined pad. For example, a pad (e.g., PAD2) connected to a shared data line Lp may be a transmit/receive combined pad, a pad (e.g., PAD1) connected to a shared clock line Lc in the first non-volatile memory device NVM11 may be a transmit-only pad, and a pad (e.g., PAD3) connected to a shared clock line Lc in the remaining non-volatile memory devices NVM12, ..., NVMmn may be a receive-only pad, but embodiments are not limited thereto.

In some embodiments, the peak information Peak_Inf associated with the command CMD may include a first level indicating a peak current section associated with the command CMD and a second level indicating a non-peak current section associated with the command CMD. For example, when a non-volatile memory device NVM11 executes a command CMD, if it enters a peak current section, peak information Peak_Inf may have a first level (e.g., logic high level). When the non-volatile memory device NVM11 executes a command CMD, if it has not entered the peak current section, the peak information Peak_Inf may have a second level (e.g., logic low level). However, embodiments are not limited thereto, and when entering a peak current section, peak information Peak_Inf may have a second level (e.g., logic low level), and when not entering a peak current section, peak information Peak_Inf may have a first level (e.g., logic high level).

FIG. 2 is illustrated as a non-volatile memory device 210 communicates with a storage controller 200 through m channels, and includes n non-volatile memory devices corresponding to each channel, but the number of channels and the number of non-volatile memory devices connected to one channel may be varied.

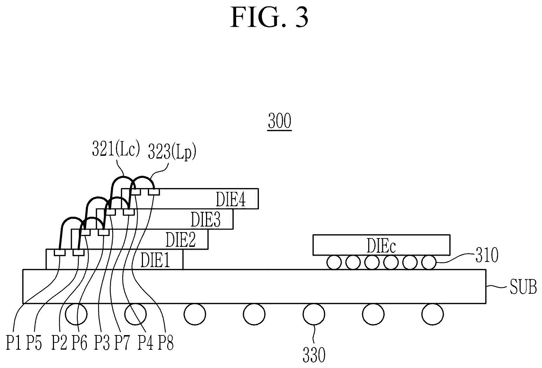

FIG. 3 is a diagram showing a semiconductor package according to some embodiments. Specifically, FIG. 3 is a diagram for explaining a structure for transmitting and receiving peak information by a plurality of memory dies according to some embodiments.

Referring to FIG. 3, a semiconductor package 300 may include a package substrate SUB, a controller die DIEc, and a plurality of memory dies DIE1, DIE2, DIE3, and DIE4.

A controller die DIEc and the plurality of memory dies DIE1, DIE2, DIE3, and DIE4 may be placed on the upper surface of a package substrate SUB. In some embodiments, the package substrate SUB may be a ceramic substrate, a PCB, an organic substrate, an interposer substrate, etc. In some embodiments, the package substrate SUB may be referred to as a board or a board substrate.

The controller die DIEc may be connected to the package substrate SUB through bump 310, and the package substrate SUB may be rewired by extending the bump 310 to an external area. Accordingly, the package substrate SUB may be referred to as a redistribution substrate. The controller die DIEc may transmit and receive signals for requests, etc., to the outside through an external connection terminal 330 located on the lower side of the package substrate SUB and a bump 310. A plurality of memory dies DIE1, DIE2, DIE3, and DIE4 may be stacked on a package substrate SUB in a direction perpendicular to the package substrate SUB, and at least some of them may overlap each other in a planar manner. Each of the plurality of memory dies DIE1, DIE2, DIE3, and DIE4 may be connected to each other through a first wire 321 connected to pads P1 to P4 arranged on each of the plurality of memory dies DIE1, DIE2, DIE3, and DIE4. Additionally, each of the plurality of memory dies DIE1, DIE2, DIE3, and DIE4 may be connected to each other through a second wire 323 connected to pads P5 to P8 arranged on each of the plurality of memory dies DIE1, DIE2, DIE3, and DIE4.

In some embodiments, a first memory die DIE1 may operate as a master device among a plurality of memory dies DIE1, DIE2, DIE3, and DIE4 and output an internal shared clock signal to another memory dies DIE2, DIE3, and DIE4 through a first wire 321. Each of the plurality of memory dies DIE1, DIE2, DIE3, and DIE4 may transmit and receive peak information through the second wire 323 in synchronization with a specific cycle of an internal shared clock signal. For example, the first memory die DIE1 may transmit peak information in synchronization with the first cycle of the internal shared clock signal, and the second memory die DIE2 may transmit peak information in synchronization with the second cycle of the internal shared clock signal.

The configuration of the semiconductor package and storage device is not limited thereto. For example, when a plurality of memory dies DIE1, DIE2, DIE3, and DIE4 transmit and receive peak information in a master-slave manner, the fourth memory die DIE4 may have a higher priority than the third memory die DIE3, the third memory die DIE3 may have a higher priority than the second memory die DIE2, and the second memory die DIE2 may have a higher priority than the first memory die DIE1. In this case, the fourth memory die DIE4 may transmit its peak information to the third memory die DIE3, the third memory die DIE3 may transmit its peak information to the second memory die DIE2, and the second memory die DIE2 may transmit its peak information to the first memory die DIE1. That is, each of the multiple memory dies DIE1, DIE2, DIE3, and DIE4 may receive peak information of a memory die with a priority one step higher than itself, and transmit peak information to a memory die with a priority one step lower than itself. Alternatively, multiple memory dies DIE1, DIE2, DIE3, and DIE4 may form multiple groups, and memory dies within the multiple groups may transmit and receive peak information in a master-slave manner. The semiconductor package 300 may include only one wire for transmitting and receiving peak information among the first wire 321 and the second wire 323.

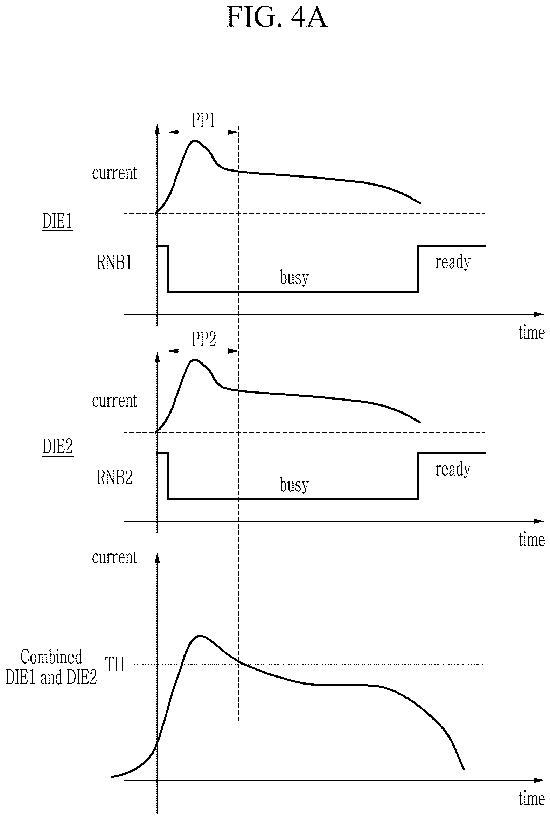

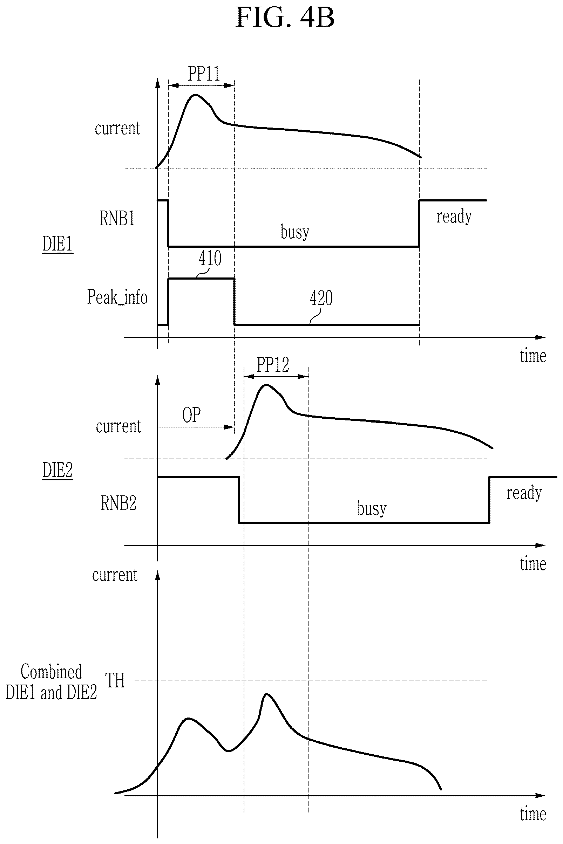

FIGS. 4A and 4B are diagrams illustrating a method of operating the memory dies of FIG. 3 according to some embodiments.

Referring to FIG. 4A, a first memory die DIE1 and a second memory die DIE2 may receive a command CMD and execute the command simultaneously. The first memory die DIE1 and the second memory die DIE2 may output ready/busy signals RNB1, RNB2 indicating a busy state, respectively, while executing a command. When the first memory die DIE1 and the second memory die DIE2 execute commands simultaneously, the peak current section PP1 of the first memory die DIE1 and the peak current section PP2 of the second memory die DIE2 may overlap.

In this way, when the peak current section PP1 of the first memory die DIE1 and the peak current section PP2 of the second memory die DIE2 overlap, the total amount of current of the storage device (e.g., the storage device 10 of FIG. 1) including the first memory die DIE1 and the second memory die DIE2 may be higher than a predetermined threshold value TH, which may deteriorate the storage device 10. Here, the predetermined threshold value TH may correspond to the power budget allocated to the storage device 10.

Referring to FIG. 4B, the first memory die DIE1 and the second memory die DIE2 may receive commands simultaneously. Hereinafter, the command received by the first memory die DIE1 is referred to as the first command, and the command received by the second memory die DIE2 is referred to as the second command. In some embodiments, the first memory die DIE1 may have higher priority than the second memory die DIE2. The first memory die DIE1 with high priority may immediately execute the first command when it receives the first command from the storage controller (storage controller 20 of FIG. 1). Additionally, the first memory die DIE1 may generate peak information Peak_Inf associated with the first command and transmit the peak information Peak_Inf associated with the first command to the second memory die DIE2.

The second memory die DIE2 may receive peak information Peak_Inf associated with the first command from the first memory die DIE1, and based on the peak information Peak_Inf, may delay execution of the second command. For example, the second memory die DIE2 may queue the second command in a command queue. In some embodiments, the peak information Peak_Inf may have a first level 410 during a peak current section PP11 associated with the first command, and may have a second level 420 when the peak current section PP11 ends. Specifically, when the peak current section PP11 of the first memory die DIE1 overlaps with the peak current section PP12 of the second memory die DIE2, the second memory die DIE2 may delay execution of the second command by queuing the second command in the command queue during the queuing section OP. Thereafter, the second memory die DIE2 may determine whether the peak current section PP11 of the first memory die DIE1 has ended based on the peak information Peak_Inf, and execute the second command in response to determining that the peak current section PP11 of the first memory die DIE1 has ended. Accordingly, the total current amount of the storage device 10 may remain lower than a predetermined threshold value TH, and the power consumed by the storage device 10 may be managed below the power budget.

In some embodiments, the storage controller 20 may detect abnormal operation of the current management circuit within the first memory die DIE1 and the second memory die DIE2 from the ready/busy signals RNB1, RNB2 of the first memory die DIE1 and the second memory die DIE2. The storage controller 20 may compare the time at which the ready/busy signal RNB1, RNB2 transitions from a busy state (e.g., logic low level) to a ready state (e.g., logic high level) with the predicted operation completion time of each memory die. The storage controller 20 may detect abnormal operation of the current management circuit based on the comparison results. In some embodiments, the timing at which the ready/busy signal RNB1, RNB2 transitions from a busy state (logic low level) to a ready state (logic high level) may be significantly earlier or later than the expected completion time of the operation. For example, despite the peak information Peak_Inf of the first memory die DIE1, the second memory die DIE2 may immediately execute the second command upon receiving the second command, or even though the peak current section has ended according to the peak information Peak_Inf of the first memory die DIE1, the second memory die DIE2 may not perform an operation according to the second command. A storage controller 20 according to some embodiments may enter a test mode for testing the performance of a current management circuit if the time at which a ready/busy signal RNB1, RNB2 changes from a busy state (logic low level) to a ready state (logic high level) is too early or late compared to the expected operation completion time.

However, embodiments are not limited thereto, and the storage controller 20 may enter a test mode for the current management circuit at a predetermined cycle.

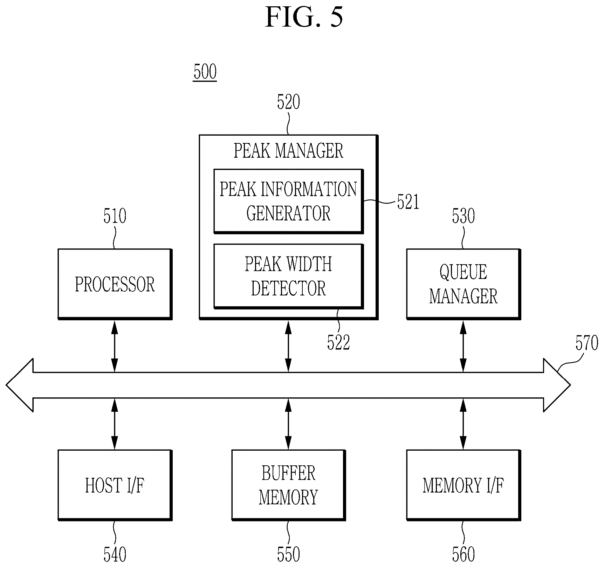

FIG. 5 is a block diagram of the storage controller of FIG. 1.

In some embodiments, the storage controller 500 may include a processor 510, a peak manager 520, a queue manager 530, a host interface 540, a buffer memory 550, a memory interface 560, and a bus 570.

The bus 570 may provide a channel between components of the storage controller 500.

The host interface 540 is configured to communicate with an external device(e.g., host device) under the control of the processor 510. The host interface 540 may be configured to communicate using at least one of various communication methods, such as Universal Serial Bus (USB), Serial AT Attachment (SATA), Small Computer System Interface (SCSI), Serial Attached SCSI (SAS), High Speed Interchip (HSIC), Peripheral Component Interconnection (PCI), PCIexpress (PCIe), Non-Volatile Memory express (NVMe), Universal Flash Storage (UFS), Secure Digital (SD), MultiMedia Card (MMC), embedded MMC (eMMC), Dual In-line Memory Module (DIMM), Registered DIMM (RDIMM), Load Reduced DIMM (LRDIMM), etc.

Buffer memory 550 may store commands and data executed and processed by the storage controller 500. Buffer memory 550 may temporarily store data that is stored in a non-volatile memory device or data that is to be stored. In some embodiments, the buffer memory 550 may store reference values for operating parameters of a plurality of non-volatile memory devices. Here, the reference value may be an initial set value for the operating parameter or a first measured value for the operating parameter. Additionally, the operating parameters may include, but are not limited to, program time tPROG, read time tR, etc.

The memory interface 560 is configured to communicate with a plurality of non-volatile memory devices under the control of the processor 510. The memory interface 560 may be implemented to comply with standard protocols such as Toggle or ONFI.

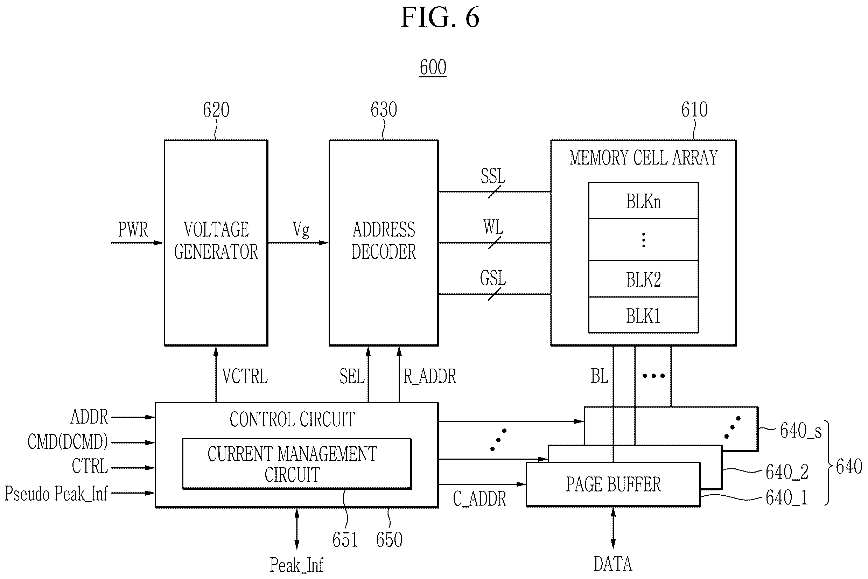

The processor 510 may control the overall operation of the storage controller 500 and perform logical operations. In some embodiments, the processor 510 may determine to enter a test mode to test the performance of the current management circuits (e.g., the current management circuits 31_1, 33_1 of FIG. 1) based on a ready/busy signal of the non-volatile memory device (non-volatile memory device 30 of FIG. 1). In some embodiments, the processor 510 may generate a dummy command for testing the current management circuit and transmit the dummy command to the non-volatile memory device 30. For example, a dummy command may be a program command for testing a current management circuits 31_1, 33_1 and may cause voltage to be cut off for some logic within a non-volatile memory device 30. Although the explanation herein assumes that the dummy command is a program command, embodiments are not limited thereto, and the dummy command may be a read command or an erase command. The voltage to some logic within the non-volatile memory device 30 may be cut off by a dummy command. A description of the structure of the non-volatile memory device 30 and the operation method of the non-volatile memory device 30 using a dummy command will be described later with reference to FIG. 6 to FIG. 8.

FIG. 6 is a block diagram of the non-volatile memory device of FIG. 1.

As shown in FIG. 6, the non-volatile memory device 600 may include a memory cell array 610, a voltage generator 620, an address decoder 630, a page buffer 640, and control logic 650.

The memory cell array 610 may include a plurality of memory blocks BLK1, BLK2, ..., BLKn. Each of the plurality of memory blocks BLK1, BLK2, ..., BLKn may be connected to an address decoder 630 through a wordline WL, a string select line SSL, and a ground select line GSL, and may be connected to a page buffer 640 through a bitline BL.

The memory cell array 610 may include a plurality of memory cells disposed in the regions intersects a plurality of wordlines WL and a plurality of bitlines BL. Each memory cell may be used as a cell type such as single level cell SLC, multilevel cell MLC, triple level cell TLC, quad level cell QLC, etc.

The memory cell array 610 may include non-volatile memory cells. For example, the memory cell array 610 may include a two-dimensional 2D NAND memory array or a three-dimensional 3D vertical NAND (V-NAND) memory array.

The voltage generator 620 may receive power PWR, regulate a voltage signal Vg for memory operation based on a voltage control signal VCTRL, and provide the voltage signal Vg to the memory cell array 610 through the address decoder 630.

The voltage generator 620 may generate various types of voltages for performing program and erase operations on the memory cell array 610 based on the voltage control signal VCTRL.

The address decoder 630 may be connected to the memory cell array 610 via the plurality of wordlines WL, the plurality of string select lines SSL, and the plurality of ground select lines GSL. The address decoder 630 may decode a row address R_ADDR to select at least one of a plurality of memory blocks BLK1, BLK2, ..., BLKn. That is, the address decoder 630 may select a wordline WL, a string select line SSL, and a ground select line GSL using a row address R_ADDR. The address decoder 630 may provide a voltage signal Vg supplied from a voltage generator 620 to the wordline WL.

The page buffer 640 may include first to sth page buffers 640_1, 640_2, ..., 640_s. The first to sth page buffers 640_1, 640_2, ..., 640_s may each be connected to the plurality of memory cells via the plurality of bit lines BLs (s is an integer greater than or equal to 3). The page buffer 640 may select at least one bit line among the plurality of bit lines BL based on a column address C_ADDR.

The control logic 650 may provide each control signal related to the memory operation to the voltage generator 620, the address decoder 630, and the page buffer 640. The control logic 650 may control the overall operation of the non-volatile memory device 600. The control logic 650 may control the non-volatile memory device 600 using an internal control signal based on at least one of an address ADDR, a command CMD, and a control signal CTRL received from the storage controller (storage controller 20 of FIG. 1).

In some embodiments, the control logic 650 may include a current management circuit 651. The current management circuit 651 may output peak information Peak_Inf of the non-volatile memory device 600 regarding a command CMD received from the storage controller 20. The current management circuit 651 may receive peak information Peak_Inf from another non-volatile memory device of the storage device (storage device 10 of FIG. 1). The current management circuit 651 may determine the execution timing of the command (CMD) based on peak information Peak_Inf received from another non-volatile memory device.

In some embodiments, the control logic 650 may receive a dummy command DCMD and pseudo peak information (Pseudo Peak_Inf) for testing the current management circuit 651 from the storage controller 20. The current management circuit 651 may determine the execution timing of the dummy command DCMD based on the dummy command DCMD and pseudo peak information (Pseudo Peak_Inf).

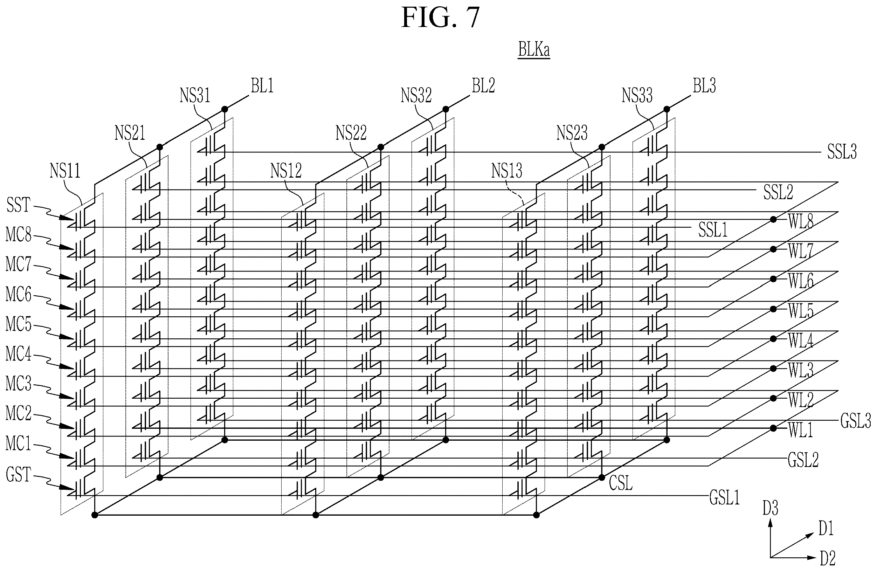

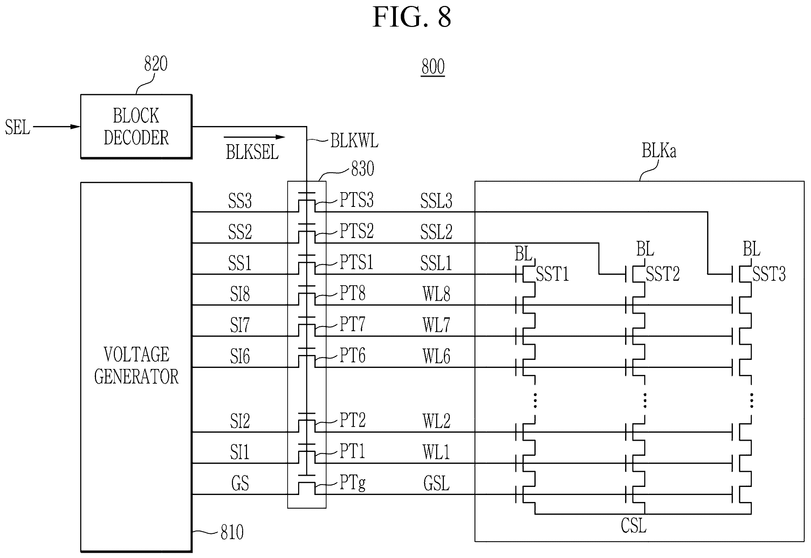

In some embodiments, the control logic 650 may output selection signal SEL to control the address decoder 630 based on the dummy command DCMD. The address decoder 630 may not select any block within the memory cell array 610 based on the selection signal SEL being a logic high level. A non-volatile memory device 600 may block a voltage applied to a wordline WL of a memory block based on a dummy command DCMD. A detailed explanation of this is provided with reference to FIG. 7 and FIG. 8.

FIG. 7 is a circuit diagram for explaining a memory block of the memory cell array of FIG. 6. Each of the plurality of memory blocks BLK1, BLK2, ..., BLKn included in the memory cell array 610 of FIG. 6 may have a structure identical to or similar to the memory block BLKa of FIG. 7.

Referring to FIG. 7, a memory block BLKa may include plurality of memory NAND strings NS11, NS12, ..., NS33 connected between a plurality of bit lines BL1, BLK2, BL3 and a common source line CSL extending in a first direction D1.

Each of the plurality of memory NAND strings NS11, NS12, ..., NS33 may include a string select transistor SST, a plurality of memory cells MC1, MC2, ..., MC8, and a ground select transistor GST. The gate of the string select transistor SST may be connected to the corresponding string select line SSL1, SSL2, SSL3. Multiple memory cells MC1, MC2, ..., MC8 may each be connected to a corresponding wordline WL1, WL2, ..., WL8. THE wordline WL1, WL2, ..., WL8 may be a gate line. The gate of the ground select transistor GST may be connected to the corresponding ground select line GSL1, GSL2, GSL3. The string select transistor SST may be connected to the corresponding bit line BL1, BL2, BL3, and the ground select transistor GST may be connected to the common source line CSL.

The memory cells located at the same height among the plurality of memory cells MC1, MC2, ..., MC8 of each of the plurality of memory NAND strings NS11, NS12, ..., NS33 may share the same wordline WL. For example, the first memory cell MC1 of each of the plurality of memory NAND strings NS11, NS12, ..., NS33 may share the first word line WL1. The second memory cell MC2 of each of the plurality of memory NAND strings NS11, NS12, ..., NS33 may share a second word line WL2. Similarly, the third to eighth memory cells MC3 to MC8 of each of the plurality of memory NAND strings NS11, NS12, ..., NS33 may respectively share the third to eighth word lines WL3 to WL8.

Memory cells sharing the same wordline may form a physical page PAGE. For example, a physical page PAGE may include memory cells arranged in an area where a word line WL4 and the plurality of bit lines BL1, BL2, BL3 intersect. A NAND flash memory device having a structure such as FIG. 4 may perform erasing in block units and program operations in physical page PAGE units corresponding to each word line WL1, WL2, ..., WL8.

The memory block BLKa illustrated in FIG. 7 is exemplary, and the number of memory NAND strings (NS), the number of cell transistors (GST, MC, SST, etc.), and the number of lines (BL, WL, CSL, SSL, GSL, etc.) connected to the cell transistors may be increased or decreased.

FIG. 8 is a diagram for explaining operation of a non-volatile memory device according to some embodiments. Specifically, a method of operating a non-volatile memory device that receives a dummy command in a test mode for testing a current management circuit is described.

In some embodiments, a non-volatile memory device 800 may include a memory block BLKa, a voltage generator 810, a block decoder 820, and a pass transistor circuit 830. The memory block BLKa may correspond to the memory block BLKa of FIG. 7, and the voltage generator 810 may correspond to the voltage generator 620 of FIG. 6. The block decoder 820 and pass transistor circuit 830 may be included in the address decoder 630 of FIG. 6. The block decoder 820 may provide the block select signal BLKSEL to the pass transistor circuit 830 through the block select line BLKWL.

The block select signal BLKSEL may be provided to the gate terminals of a plurality of pass transistors PTS1, PTS2, PTS3, PT1 to PT8, PTg included in the pass transistor circuit 830. For example, when the block select signal BLKSEL is activated, a plurality of pass transistors PTS1, PTS2, PTS3, PT1 to PT8, PTg in the pass transistor circuit 830 are turned on, and accordingly, the memory block BLKa may be selected. Although one block select line BLKWL is illustrated as being commonly connected to the plurality of pass transistors PTS1, PTS2, PTS3, PT1 to PT8, PTg, embodiments are not limited thereto. In some embodiments, at least two of the plurality of pass transistors PTS1, PTS2, PTS3, PT1 to PT8, PTg may be respectively connected to two or more block select lines. The non-volatile memory device 800 may include a plurality of memory blocks and may perform a memory operation on a memory block selected based on a block select signal BLKSEL.

The voltage generator 810 may be connected to the pass transistor circuit 830 through the string select line drive signal lines SS1, SS2, SS3, the word line drive signal lines SI1, SI1, ..., SI8, and the ground select line drive signal line GS. Specifically, the string select line driving signal lines SS1, SS2, SS3, the word line driving signal lines SI1, SI2, ..., SI8, and the ground select line driving signal line GS may each be connected to one end of a plurality of pass transistors (PTS1, PTS2, PTS3, PT1 to PTn, PTg) in the pass transistor circuit 830.

The pass transistor circuit 830 may be connected to the memory block BLKa through string select lines SSL1, SSL2, SSL3, a plurality of word lines WL1, WL2, ..., WL8, and a ground select line GSL.

When the block select signal BLKSEL is activated, the plurality of pass transistors (PTS1, PTS2, PTS3, PT1 to PT8, PTg) may provide driving signals provided through the string select line driving signal lines SS1, SS2, SS3, the word line driving signal lines SI1, SI2, ..., SI8, and the ground select line driving signal line GS to the string select lines SSL1, SSL2, SSL3, the plurality of word lines WL1, WL2, ..., WL8, and the ground select line GSL, respectively.

In some embodiments, the control logic (control logic 650 of FIG. 6) may output the selection signal SEL to the block decoder 820 within the address decoder 630 based on the dummy command DCMD received from the storage controller. For example, when the block decoder 820 receives a selection signal SEL of a logic high level, the block decoder 820 may deactivate the block selection signal BLKSEL input to the pass transistor circuit 830 through the block selection line BLKWL. Specifically, the block decoder 820 may block the voltage applied to the word lines WL1, WL2, ..., WL8 of the memory block BLKa from the voltage generator 810 by deactivating the block select signal BLKSEL provided to the gate terminal of the pass transistor circuit 830 through the block select line BLKWL. This applies equally to all memory blocks (memory blocks BLK1, BLK2, ..., BLKn in FIG. 6) in the non-volatile memory device 800. A non-volatile memory device 800 according to some embodiments may deactivate a block select signal BLKSEL provided to a gate terminal of a pass transistor circuit 830 so as not to select all memory blocks within the non-volatile memory device 800. This may prevent unnecessary program/erase cycles from being performed on the memory block BLKa in test mode.

Referring to FIG. 5, the storage controller 500 includes a peak manager 520, and the peak manager 520 may include a peak information generator 521 and a peak width detector 522. When the storage controller 500 outputs a dummy command DCMD in test mode, the peak information generator 521 may output the pseudo-peak information to a plurality of non-volatile memory devices 31, 33 so that the current management circuit 31_1, 33_1 controls the execution timing of the dummy command. The pseudo-peak information may include a first level representing a peak current section and a second level representing a non-peak current section. The pseudo-peak information may be maintained at the first level during the peak current section.

In some embodiments, the peak width detector 522 may receive elapsed time information by dummy commands from the plurality of non-volatile memory devices 31, 33 and determine, or identify, a failed current management circuit using the elapsed time information. A detailed description of the peak width detector 522 and elapsed time information is provided with reference to FIG. 9 to FIG. 11.

FIG. 9 to FIG. 11 are timing diagrams for explaining an operating method of a non-volatile memory device according to some embodiments.

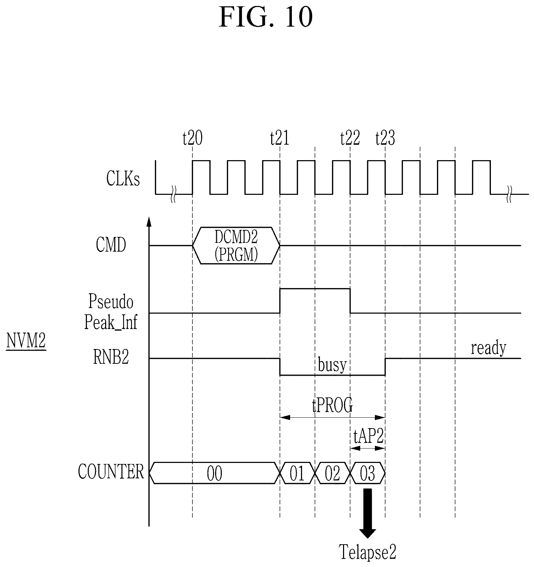

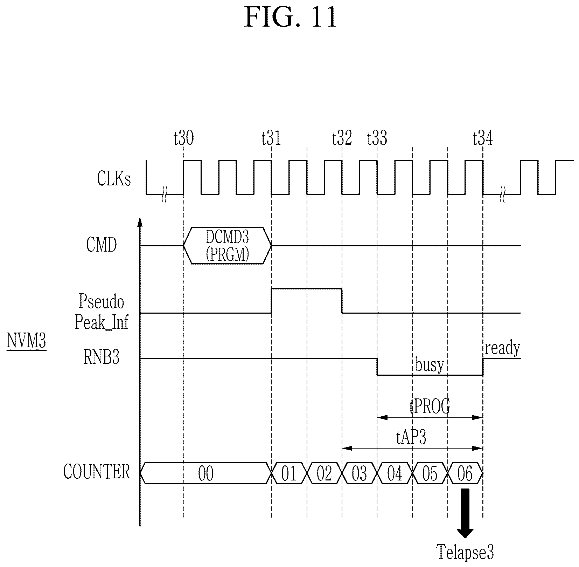

Specifically, FIG. 9 to FIG. 11 illustrate how a non-volatile memory device that receives a dummy command DCMD and pseudo peak information (Pseudo Peak_Inf) in test mode generates elapsed time information Telapse. In each drawing, the non-volatile memory device may correspond to one of the non-volatile memory devices described in FIG. 1 to FIG. 8, and for convenience of explanation, it is assumed that the non-volatile memory device according to FIG. 9 includes a normal current management circuit, and the non-volatile memory devices according to FIG. 10 and FIG. 11 include a failed current management circuit. The clock signal CLKs may be a clock signal received from an external source or an internal clock signal of a non-volatile memory device. In some embodiments, the non-volatile memory device may receive a dummy command DCMD and pseudo peak information (Pseudo Peak_Inf) in a test mode. In the test mode, a non-volatile memory device may not generate peak information for a dummy command DCMD or may not share peak information for a dummy command DCMD. In the test mode, the non-volatile memory device may queue a dummy command DCMD in a command queue based on the pseudo peak information, and execute the dummy command DCMD when the peak current section according to the pseudo peak information ends.

Referring to FIG. 9, a first non-volatile memory device NVM1 may receive a first dummy command DCMD1 instructing a program operation from a storage controller at time t10. The first non-volatile memory device NVM1 may receive the pseudo peak information (Pseudo Peak_Inf) from the storage controller at t11.

The pseudo peak information (Pseudo Peak_Inf) may be indicated by a signal. A logic high level of the signal indicates the peak current section. In this regard, the pseudo peak information (Pseudo Peak_Inf) shown in FIG. 9 indicates the peak current section from time t11 to time t12. The first non-volatile memory device NVM1 may queue the first dummy command DCMD1 in the command queue during the peak current section (from time t11 to time t12) according to pseudo peak information (Pseudo Peak_Inf). The first non-volatile memory device NVM1 may determine whether the peak current section has ended (i.e., when the pseudo peak information (Pseudo Peak_Inf) changes to a logic low level), and if the peak current section according to the pseudo peak information (Pseudo Peak_Inf) has ended at time t12, the first non-volatile memory device NVM1 may execute an operation according to the first dummy command DCMD1.

In some embodiments, the first non-volatile memory device NVM1 may output a first ready/busy signal RNB1 indicating the busy state while performing the internal operations in accordance with the first dummy command DCMD1. In some embodiments, the actual internal operation time (from time t12 to time t13) according to the first dummy command DCMD1 may be equal to, but is not limited to, a predetermined program time tPROG of the first non-volatile memory device NVM1. According to some embodiments, because the block select signal BLKSEL is inactive while internal operations are performed according to the first dummy command DCMD1, only some logic within the non-volatile memory device (non-volatile memory device 600 of FIG. 6) may operate.

In some embodiments, the first non-volatile memory device NVM1 may further include a counter. Specifically, the counter may count cycles of the clock signal CLKs from the time when the first non-volatile memory device NVM1 receives pseudo peak information (Pseudo Peak_Inf) of a logic high level to the time when the actual internal operation according to the first dummy command DCMD1 is completed. Referring to FIG. 9, the counter may count the cycles of the clock signal CLKs from the time t11 when the first non-volatile memory device NVM1 receives pseudo peak information (Pseudo Peak_Inf) of a logic high level to the time t13 when the first ready/busy signal RNB1 changes from a busy state to a ready state, and may output the count information '5' as the first elapsed time information Telapse1.

In some embodiments, the peak width detector (peak width detector 522 of FIG. 5) may obtain the internal operation time of the first non-volatile memory device NVM1 from the first elapsed time information Telapse1. Specifically, the peak width detector 522 may determine the remaining time excluding the peak current section of the pseudo peak information (Pseudo Peak_Inf) from the first elapsed time information Telapse1 as the internal operation time tAP1 of the first non-volatile memory device NVM1.

In some embodiments, the peak width detector 522 may compare the reference value of the internal operation time tPROG with the internal operation time tAP1 of the first non-volatile memory device NVM1 obtained from the first elapsed time information Telapse1. The reference value of the internal operation time may be an initial setting value determined in advance according to the specifications of the non-volatile memory device, or may be a value stored in a buffer memory 550 within the storage controller (storage controller 500 of FIG. 5) as the first measured value. The peak width detector 522 may determine that the difference between the reference value of the internal operation time tPROG and the internal operation time tAP1 obtained from the first elapsed time information Telapse1 is within a predetermined range, and the current management circuit in the first non-volatile memory device NVM1 may be determined to be operating normally.

Referring to FIG. 10, the second non-volatile memory device NVM2 may receive a second dummy command DCMD2 instructing a program operation at time t20, and perform an internal operation according to the second dummy command DCMD2 during a peak current section (from time t21 to time t22) according to pseudo peak information (Pseudo Peak_Inf). Specifically, the second non-volatile memory device NVM2 may output a second ready/busy signal RNB2 indicating a busy state from time t21 to time t23 by performing an internal operation according to the second dummy command DCMD2, even though the second dummy command DCMD2 should be queued in a command queue during a peak current section (from time t21 to time t22) according to pseudo peak information (Pseudo Peak_Inf). In some embodiments, the time (from time t21 to time t23) for performing an actual internal operation according to the second dummy command DCMD2 may be equal to, but is not limited to, a predetermined program time tPROG of the second non-volatile memory device NVM2.

In some embodiments, a counter within the second non-volatile memory device NVM2 may count cycles of the clock signal CLKs from a time when the second non-volatile memory device NVM2 receives pseudo peak information (Pseudo Peak_Inf) of a logic high level until a time when the second non-volatile memory device NVM2 completes an actual internal operation according to the second dummy command DCMD2. Referring to FIG. 10, the counter may count the cycles of the clock signal CLKs from the time t21 when the second non-volatile memory device NVM2 receives pseudo peak information (Pseudo Peak_Inf) of a logic high level to the time t23 when the second ready/busy signal RNB2 changes from a busy state to a ready state, and may output the count information '3' as the second elapsed time information Telapse2.

In some embodiments, the peak width detector 522 may determine the remaining time excluding the peak current section of the pseudo peak information (Pseudo Peak_Inf) from the second elapsed time information Telapse as the internal operation time tAP2 of the second non-volatile memory device NVM2. In some embodiments, the peak width detector 522 may compare a reference value of the internal operation time tPROG with the internal operation time tAP2 of the second non-volatile memory device NVM2 obtained from the second elapsed time information Telapse2, and determine that the difference between the reference value of the internal operation time tPROG and the internal operation time tAP2 is greater than a predetermined range. Accordingly, the peak width detector 522 may determine that the second non-volatile memory device NVM2 includes a failed current management circuit and may turn off power to (or disable) the failed current management circuit within the second non-volatile memory device NVM2.

Referring to FIG. 11, the third non-volatile memory device NVM3 does not perform an internal operation according to the third dummy command DCMD3 even though the peak current section (from time t31 to time t32) according to the pseudo peak information (Pseudo Peak_Inf) has ended. Specifically, at time t32, although the pseudo peak information (Pseudo Peak_Inf) transitions from a logic high level to a logic low level, the internal operation according to the third dummy command DCMD3 is not performed. The third non-volatile memory device NVM3 performs the internal operation according to the third dummy command DCMD3 at time t33. In some embodiments, the time (from time t33 to time t34) for performing the actual internal operation according to the third dummy command DCMD3 may be equal to, but is not limited to, the predetermined program time tPROG.

In some embodiments, a counter within the third non-volatile memory device NVM3 may count cycles of the clock signal CLKs from a time when the third non-volatile memory device NVM3 receives pseudo peak information (Pseudo Peak_Inf) of a logic high level until a time when the third non-volatile memory device NVM3 completes an actual internal operation according to the third dummy command DCMD3. Referring to FIG. 11, the counter may count the cycles of the clock signal CLKs from the time t31 when it receives pseudo peak information (Pseudo Peak_Inf) of a logic high level to the time t34 when the third ready/busy signal RNB3 changes from a busy state to a ready state, and may output the count information '6' as the third elapsed time information Telapse3.

In some embodiments, the peak width detector 522 may determine the remaining time excluding the peak current section of the pseudo peak information (Pseudo Peak_Inf) from the third elapsed time information Telapse3 as the internal operation time tAP3 of the third non-volatile memory device NVM3. In some embodiments, the peak width detector 522 may compare the reference value of the internal operation time tPROG with the internal operation time tAP3 of the third non-volatile memory device NVM3 obtained from the third elapsed time information Telapse3, and determine that the difference between the reference value of the internal operation time tPROG and the internal operation time tAP3 is greater than a predetermined range. Accordingly, the peak width detector 522 determines that the third non-volatile memory device NVM3 includes a failed current management circuit and may turn off power to (or disable) the failed current management circuit within the third non-volatile memory device NVM3.

It is assumed here that the dummy command DCMD is a program command, and the actual internal operation time of the non-volatile memory device according to the dummy command DCMD is the program time tPROG, but embodiments are not limited thereto. For example, the dummy command DCMD may be a read command, and the actual internal operation time of the non-volatile memory device according to the dummy command DCMD may be the read time tR.

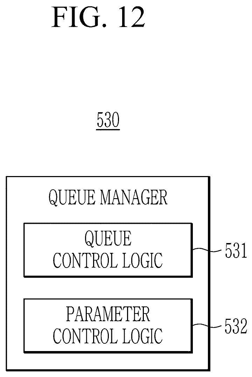

Referring to FIG. 5, in some embodiments, the storage controller 500 may include queue manager 530. The queue manager 530 may determine a command to be transmitted to a non-volatile memory device including a failed current management circuit, or determine a time to transmit a command to a non-volatile memory device including a failed current management circuit. Alternatively, the queue manager 530 may change the setting values of the operating parameters of the non-volatile memory device including the failed current management circuit. A detailed description of the queue manager 530 is provided with reference to FIG. 12 to FIG. 15.

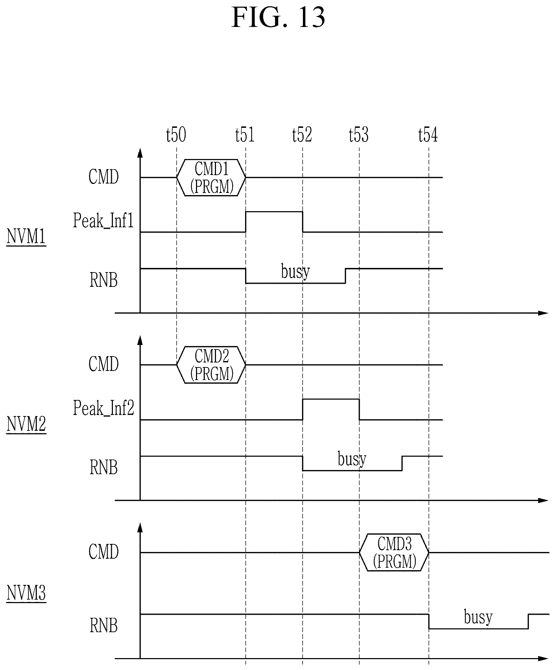

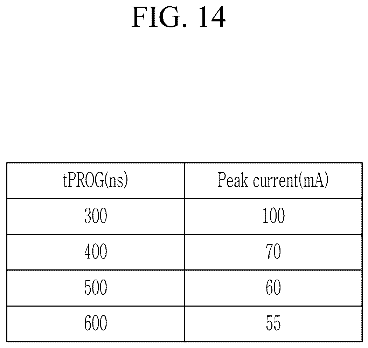

FIG. 12 is a block diagram of a queue manager according to some embodiments, FIG. 13 is a timing diagram for explaining an operation method of the queue manager according to some embodiments, and FIG. 14 is a diagram showing peak current values according to parameter setting values of a non-volatile memory device according to some embodiments.

In some embodiments, the queue manager 530 may include queue control logic 531 and parameter control logic 532.

In some embodiments, the queue control logic 531 may determine a command to transmit to a non-volatile memory device that includes a failed current management circuit. The queue control logic 531 may assign a command having a relatively low peak current to a non-volatile memory device including a failed current management circuit based on peak information. Specifically, the queue control logic 531 may assign a command having a relatively low peak current to a non-volatile memory device including a failed current management circuit based on peak information of the non-volatile memory device so that the peak current of the storage device 10 does not exceed the maximum current value due to the operation of a plurality of non-volatile memory devices. Here, a command with a relatively low peak current may refer to, but is not limited to, a read command.

In some embodiments, the queue control logic 531 may determine when to transmit a command to a non-volatile memory device including a failed current management circuit. Referring to FIG. 13, it is assumed that the third non-volatile memory device NVM3 includes a failed current management circuit.

In some embodiments, the first non-volatile memory device NVM1 and the second non-volatile memory device NVM2 may receive a first command CMD1 and a second command CMD2, respectively, at time t50. The first non-volatile memory device NVM1 and the second non-volatile memory device NVM2 may determine the operation times of the first command CMD1 and the second command CMD2 based on their respective peak information. For example, the first non-volatile memory device NVM1 may output first peak information Peak_Inf1 regarding the first command CMD1 and execute the first command CMD1 at time t51. The second non-volatile memory device NVM2 may queue the second command CMD2 in a command queue based on the first peak information Peak_Inf1. The second non-volatile memory device NVM2 may output the second peak information Peak_Inf2 at time t52 when the peak current section of the first non-volatile memory device NVM1 ends, and perform the second command CMD2.

In some embodiments, the queue control logic 531 may receive first peak information Peak_Inf1 from the first non-volatile memory device NVM1 and second peak information Peak_Inf2 from the second non-volatile memory device NVM2, and determine the transmission timing of the third command CMD3. For example, the queue control logic 531 may control the sum of the peak currents of the plurality of non-volatile memory devices NVM1, NVM2, NVM3 to not exceed the maximum current value by transmitting a third command CMD3 at time t53 when the peak current section of the second non-volatile memory device NVM2 ends based on the first peak information Peak_Inf1 and the second peak information Peak_Inf2. Accordingly, the total current of the plurality of storage devices NVM1, NVM2, NVM3 may be lower than the maximum current, and the power consumed by the plurality of storage devices NVM1, NVM2, NVM3 may be managed within the scope of the power budget.

Referring to FIG. 12, in some embodiments, the queue manager 530 may include parameter control logic 532. The parameter control logic 532 may change the setting values of the operating parameters of the non-volatile memory device including a failed current management circuit. Here, the operating parameters may include, but are not limited to, program time tPROG, read time tR, etc. Specifically, as the set value of the program time tPROG of the non-volatile memory device increases, the peak current of the non-volatile memory device may decrease. For example, if the program time tPROG of a non-volatile memory device including a failed current management circuit is set to 300 ns, the peak current of the non-volatile memory device including a failed current management circuit may be reduced by changing the program time tPROG of the non-volatile memory device including a failed current management circuit to 400 ns. However, this is only an example, and actual program times and peak currents may vary.

In some embodiments, the parameter control logic 532 may change the set value of an operating parameter of a non-volatile memory device including a failed current management circuit based on a predetermined peak current value according to the set value of the operating parameter. This also allows efficient management of the power budget of the storage device without controlling the timing of command transmission to the non-volatile memory device including the failed current management circuit.

In some embodiments, the queue manager 530 may manage the power consumption of the storage device within the scope of the power budget by operating the queue control logic 531 and the parameter control logic 532 simultaneously or selectively.

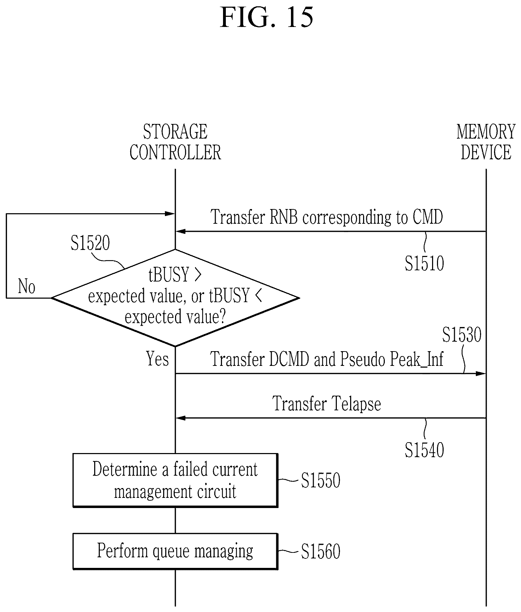

FIG. 15 is a flowchart showing a method of operating a storage device according to some embodiments.

In some embodiments, the storage controller may transmit a command to a memory device and receive a ready/busy signal RNB corresponding to the command from the memory device in operation S1510. The storage controller may detect the abnormal operation of the current management circuit in the memory device based on the read/busy signal RNB.

In some embodiments, the storage controller may compare the predicted completion time of the operation of the memory device with the time at which a read/busy signal RNB transitions from a busy state to a ready state in operation S1520. For example, the storage controller may predict when an operation of the memory device will be completed based on a command passed to the memory device, and may compare the predicted completion time of the operation of the memory device with the time at which a ready/busy signal RNB transitions from a busy state to a ready state.

The storage controller may detect abnormal operation of the current management circuit by comparing the timing at which the ready/busy signal RNB transitions from a busy state to a ready state with the timing at which the memory device's expected operation is completed. Specifically, the storage controller may enter a test mode for testing the current management circuit if the time at which the ready/busy signal RNB transitions from a busy state to a ready state is significantly greater or smaller than an expected value. For example, the storage controller may enter a test mode for testing the current management circuit if the time at which the ready/busy signal RNB transitions from a busy state to a ready state differs from the expected value by more than a threshold value. However, embodiments are not limited thereto, the storage controller may enter a test mode to test the current management circuit at predetermined period.

In some embodiments, the storage controller may generate dummy command DCMD to test the current management circuit, and transmit the dummy command DCMD to the memory device. The storage controller may transmit pseudo peak information (Pseudo Peak_Inf) to the memory device simultaneously with or subsequent to the dummy command DCMD in operation S1530. The storage controller may transmit pseudo peak information (Pseudo Peak_Inf) to the memory device to control the timing of execution of the dummy command DCMD.

In some embodiments, the memory device may transmit elapsed time information Telapse to the storage controller in response to a dummy command DCMD and pseudo peak information (Pseudo Peak_Inf) in operation S1540. Elapsed time information Telapse may include information for the actual internal operation time of the memory device according to the peak current section within the pseudo peak information (Pseudo Peak_Inf) and the dummy command DCMD.

In some embodiments, the storage controller may obtain the internal operating time of the memory device from elapsed time information Telapse. The storage device may determine the remaining time, excluding the peak current section within the pseudo peak information (Pseudo Peak_Inf) from the elapsed time information Telapse, as the internal operating time of the memory device.

In some embodiments, the storage controller may compare the internal operating time of the memory device with the set values of the operating parameters of the memory device and determine a failed current management circuit in operation S1550. For example, if a difference between the internal operating time of the memory device and the set value of the operating parameter of the memory device exceeds a threshold value, the memory device may be determined to include a failed current management circuit.

In some embodiments, a storage controller may perform queue managing operations for a memory device including a failed current management circuit (S1560). Specifically, the storage controller may assign low peak current commands to memory devices that include failed current management circuit. Alternatively, the storage controller may determine when to allocate a command to a memory device including a failed current management circuit based on peak information of the memory device. Alternatively, the storage controller may change the operating parameter settings value of the memory device including the failed current management circuit.

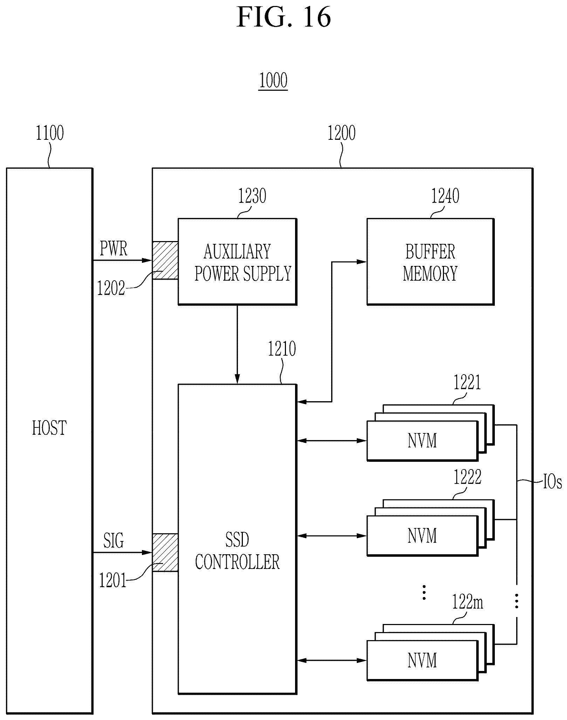

FIG. 16 is a block diagram showing an SSD system to which a storage device is applied according to some embodiments.

Referring to FIG. 16, SSD system 1000 may include host 1100 and SSD 1200. The SSD 1200 may exchange signals SIG with the host 1100 through the signal connector 1201 and receive power PWR through the power connector 1202. The SSD 1200 may include an SSD controller 1210, a plurality of flash memories 1221, 1222, 122m, an auxiliary power supply 1230, and a buffer memory 1240.

A plurality of flash memories 1221, 1222, 122m may be respectively connected to the SSD controller 1210 through a plurality of channels. The SSD controller 1210 may control the plurality of flash memories 1221, 1222, 122m in response to the signal SIG received from the host 1100. The SSD controller 1210 may store a signal generated internally or transmitted from the outside (e.g., a signal SIG received from the host 1100) in the buffer memory 1240.

The plurality of flash memories 1221, 1222, 122m may operate under the control of the SSD controller 1210. A plurality of flash memories 1221, 1222, 122m may be connected to each other through shared input/output line IOs, and the plurality of flash memories 1221, 1222, 122m may be implemented as a plurality of non-volatile memory devices described above with reference to FIG. 1 to FIG. 15. The shared input/output line IOs may correspond to the shared input/output lines IOs in FIG.2 and be applied the description of shared input/output lines IOs in FIG.2. Current management circuits within the plurality of flash memories 1221, 1222, 122m may output and share peak information containing information about peak current sections through shared input/output lines IOs.

In some embodiments, the SSD controller 1210 may test current management circuits within a plurality of flash memories 1221, 1222, 122m. The SSD controller 1210 may transmit a dummy command and pseudo-peak information for testing the current management circuits within a plurality of flash memories 1221, 1222, 122m, and may receive elapsed time information of the plurality of flash memories 1221, 1222, 122m according to the dummy command and pseudo-peak information from the current management circuits within the plurality of flash memories 1221, 1222, 122m. The SSD controller 1210 may determine a failed current management circuit among current management circuits in a plurality of flash memories 1221, 1222, 122m from elapsed time information.

In some embodiments, the SSD controller 1210 may perform queue management operations for a flash memory including a failed current circuit among a plurality of flash memories 1221, 1222, 122m. For example, the SSD controller 1210 may assign a command with a low peak current to a flash memory including a failed current management circuit, determine a command assignment timing for the flash memory including a failed current management circuit based on peak information of a plurality of flash memories 1221, 1222, 122m, or change an operation parameter setting value of the flash memory including a failed current management circuit.

The auxiliary power supply 1230 may be connected to the host 1100 via the power connector 1202. The auxiliary power supply 1230 may receive power PWR from the host 1100, and charge. The auxiliary power supply 1230 may provide power to the SSD 1200 when the power supply from the host 1100 is not smooth.

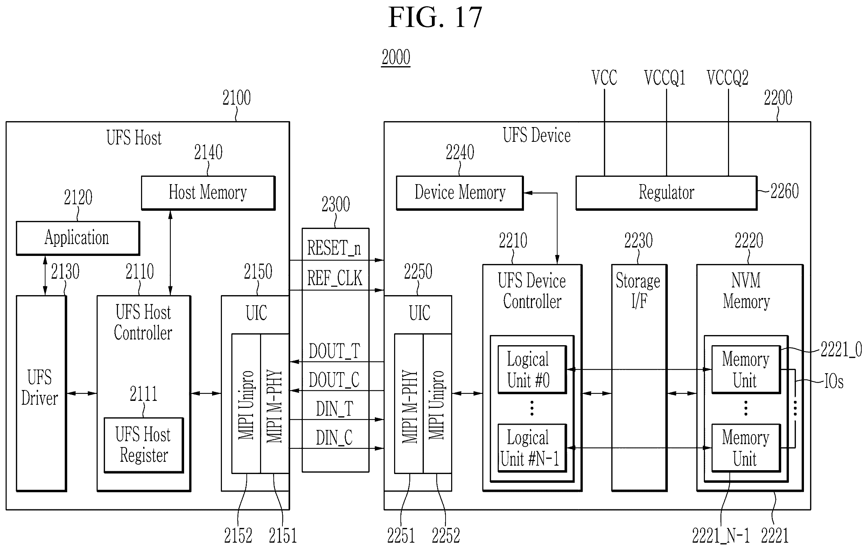

FIG. 17 is a block diagram showing a UFS system according to some embodiments.

The UFS system 2000 is a system that follows the UFS standard announced by Joint Electron Device Engineering Council (JEDEC) and may include a UFS host 2100, a UFS device 2200, and a UFS interface 2300. The description of the storage device 10 of FIG. 1 to FIG. 15 described above may also be applied to the UFS system 2000 of FIG. 17, within the scope that does not conflict with the following description of FIG. 17.

Referring to FIG. 17, a UFS host 2100 may include a UFS host controller 2110, an application 2120, a UFS driver 2130, host memory 2140, and a UFS interconnect (UIC) layer 2150. The UFS device 2200 may include UFS device controller 2210, non-volatile memory 2220, storage interface 2230, device memory 2240, UIC layer 2250, and regulator 2260. The non-volatile memory 2220 may be composed of a plurality of memory units 2221_0 to 2221_N-1, and the plurality of memory units 2221_0 to 2221_N-1 may include V-NAND flash memory having a 2D structure or a 3D structure, but may also include other types of non-volatile memory such as phase-change memory (PRAM) and/or resistive random-access memory (RRAM). The UFS device controller 2210 and the non-volatile memory 2220 may be connected to each other through a storage interface 2230. The storage interface 2230 may be implemented to comply with standard protocols such as Toggle or ONFI.

The plurality of memory units 2221_0 to 2221_N-1 may be implemented as a plurality of non-volatile memory devices described above with reference to FIG. 1 to FIG. 15, and the plurality of memory units 2221_0 to 2221_N-1 may be connected to each other through shared input/output lines IOs. The shared input/output lines IOs correspond to the shared input/output lines IOs of FIG. 2, and the description of the shared input/output lines IOs of FIG. 2 may be applied.

Each of the plurality of memory units 2221_0 to 2221_N-1 may include a memory cell array and a control circuit for controlling the operation of the memory cell array and delaying (or queuing) operation for the memory cell array to avoid overlapping of peak current periods. The above memory cell array may include a two-dimensional memory cell array or a three-dimensional memory cell array. The three-dimensional memory cell array may include vertical NAND strings that are vertically oriented such that at least one memory cell is positioned above another memory cell.

The plurality of memory units 2221_0 to 2221_N-1 may output and share peak information with each other through shared input/output lines IOs. The UFS device 2200 may avoid overlapping peak power intervals without deploying complex dedicated circuits in the UFS device controller 2210 through shared input/output lines IOs.

In some embodiments, the UFS device controller 2210 may test current management circuitry within multiple memory units 2221_0 to 2221_N-1. The UFS device controller 2210 may transmit a dummy command and pseudo-peak information for testing a current management circuit within a plurality of memory units 2221_0 to 2221_N-1, and may receive elapsed time information of the plurality of memory units 2221_0 to 2221_N-1 according to the dummy command and pseudo-peak information from the current management circuit within the plurality of memory units 2221_0 to 2221_N-1.

The UFS device controller 2210 may determine a failed current management circuit among the current management circuits in a plurality of memory units 2221_0 to 2221_N-1 from the elapsed time information.

In some embodiments, the UFS device controller 2210 may perform queue management operations for a memory unit including a failed current circuit among a plurality of memory units 2221_0 to 2221_N-1. For example, the UFS device controller 2210 may assign a command with a low peak current to a memory unit including a failed current management circuit, determine a command assignment timing for the memory unit including a failed current management circuit based on peak information of a plurality of memory units 2221_0 to 2221_N-1, or change an operation parameter setting value of the memory unit including the failed current management circuit.

The application 2120 may refer to a program that wishes to communicate with the UFS device 2200 to take advantage of the functionality of the UFS device 2200. An application 2120 may send an input-output request to a UFS driver 2130 for input/output to a UFS device 2200. An Input/Output Request IOR may mean, but is not necessarily limited to, a request to read data, a request to write data, and/or a request to discard data.

The UFS driver 2130 may manage the UFS host controller 2110 through the UFS-HCI (host controller interface). The UFS driver 2130 may convert input/output requests generated by the application 2120 into UFS commands defined by the UFS standard and transmit the converted UFS commands to the UFS host controller 2110.

UFS commands may be commands defined primarily by the SCSI standard, but may also be UFS standard-specific commands.

The UFS host controller 2110 may transmit the UFS command converted by the UFS driver 2130 to the UIC layer 2250 of the UFS device 2200 through the UIC layer 2150 and the UFS interface 2300. In this process, a UFS host register 2111 of the UFS host controller 2110 may serve as a command queue.

The UIC layer 2150 on the UFS host 2100 side may include MIPI M-PHY 2151 and MIPI UniPro 2152, and the UIC layer 2250 on the UFS device 2200 side may also include MIPI M-PHY 2251 and MIPI UniPro 2252.

The UFS interface 2300 may include a line transmitting a reference clock (REF_CLK), a line transmitting a hardware reset signal (RESET_n) for the UFS device 2200, a pair of lines transmitting a differential input signal pair (DIN_t and DIN_c), and a pair of lines transmitting a differential output signal pair (DOUT_t and DOUT_c).

The frequency value of the reference clock provided from the UFS host 2100 to the UFS device 2200 may be one of four values: 19.2 MHz, 26 MHz, 38.4 MHz, and 52 MHz, but embodiments are not limited thereto. The UFS host 2100 may change the frequency value of the reference clock even while in operation, that is, while data transmission and reception are performed between the UFS host 2100 and the UFS device 2200. The UFS device 2200 may generate clocks of various frequencies from a reference clock provided from the UFS host 2100 using a phase-locked loop PLL, etc. Additionally, the UFS host 2100 may also set the data rate value between the UFS host 2100 and the UFS device 2200 through the frequency value of the reference clock. That is, the value of the data rate may be determined depending on the frequency value of the reference clock.

The UFS interface 2300 may support multiple lanes, and each lane may be implemented as a differential pair. For example, a UFS interface may include one or more reception lanes and one or more transmission lanes. In FIG. 17, a pair of lines transmitting a differential input signal pair (DIN_T and DIN_C) may constitute a reception lane, and a pair of lines transmitting a differential output signal pair (DOUT_T and DOUT_C) may constitute a transmission lane. Although FIG. 17 illustrates one transmission lane and one reception lane, the number of transmission lanes and reception lanes may be changed.

The reception lane and the transmission lane may transmit data in a serial communication manner, and full-duplex communication between the UFS host 2100 and the UFS device 2200 is possible due to the structure in which the reception lane and the transmission lane are separated.

Additionally, control data such as commands from a UFS host 2100 to a UFS device 2200 and user data that the UFS host 2100 wants to store in or read from a non-volatile memory 2220 of the UFS device 2200 may be transmitted through the same lane. Accordingly, there is no need to provide a separate lane for data transmission between the UFS host 2100 and the UFS device 2200 other than a pair of reception lanes and a pair of transmission lanes.

The UFS device controller 2210 of the UFS device 2200 may control the overall operation of the UFS device 2200. The UFS device controller 2210 may manage non-volatile memory 2220 through a logical unit (LU) 2211, which is a logical data storage unit.

The UFS device controller 2210 may include a flash translation layer (FTL) and may convert a logical data address, such as a logical block address (LBA), transmitted from a UFS host 2100 into a physical data address, such as a physical block address (PBA), using address mapping information of the FTL. In a UFS system 2000, a logical block for storing user data may have a size within a predetermined range. For example, the minimum size of a logical block may be set to 4 Kbytes.

When a command from a UFS host 2100 is input to a UFS device 2200 through a UIC layer 2250, the UFS device controller 2210 may perform an operation according to the input command and, when the operation is completed, transmit a completion response to the UFS host 2100.

In one example, if the UFS host 2100 wants to store user data on UFS device 2200, the UFS host 2100 may send data storage instructions to the UFS device 2200. When a response indicating that user data is ready to be transferred (ready-to-transfer) is received from the UFS device 2200, the UFS host 2100 may transfer the user data to the UFS device 2200. The UFS device controller 2210 may temporarily store the received user data in the device memory 2240, and store the user data temporarily stored in the device memory 2240 in a selected location of the non-volatile memory 2220 based on the address mapping information of the FTL.

As another example, when the UFS host 2100 wants to read user data stored in the UFS device 2200, the UFS host 2100 may transmit a data read command to the UFS device 2200. The UFS device controller 2210 that receives the command may read user data from the non-volatile memory 2220 based on the data read command and temporarily store the read user data in the device memory 2240. During this read process, the UFS device controller 2210 may detect and correct errors in the read user data using a built-in error correction code (ECC) engine. More specifically, the ECC engine may generate parity bits for write data to be written to non-volatile memory 2220, and the parity bits thus generated may be stored in the non-volatile memory 2220 together with the write data. When reading data from non-volatile memory 2220, the ECC engine may correct errors in the read data using parity bits read from the non-volatile memory 2220 together with the read data, and output the read data with the errors corrected.

Additionally, the UFS device controller 2210 may transmit user data temporarily stored in the device memory 2240 to the UFS host 2100.

The AES engine may perform at least one of an encryption operation and a decryption operation on data input to the UFS device controller 2210 using a symmetric key algorithm.

The UFS host 2100 may sequentially store commands to be transmitted to the UFS device 2200 in the UFS host register 2111 that may function as a command queue, and transmit the commands to the UFS device 2200 in the sequential order. At this time, the UFS host 2100 may transmit the next command waiting in the command queue to the UFS device 2200 even if the previously transmitted command is still being processed by the UFS device 2200, that is, even before receiving a notification that the previously transmitted command has been completed by the UFS device 2200, and accordingly, the UFS device 2200 may also receive the next command from the UFS host 2100 even while processing the previously transmitted command. The maximum number of instructions that can be stored in such an instruction queue (queue depth) can be, for example, 32. Additionally, the command queue may be implemented as a circular queue type that indicates the start and end of the command sequence stored in the queue through a head pointer and a tail pointer, respectively.

The UFS host 2100 may determine the total power available in the UFS system 2000 and determine the amount of power that may be allocated to the UFS device 2200 from the determined total power. The UFS host 2100 may, but is not limited to, communicate the power budget allocated to the UFS device 2200 to the UFS device controller 2210.

VCC, VCCQ, VCCQ2, etc., may be input as power voltage to the UFS device 2200.

VCCQ is a power supply voltage for supplying a low range of voltage, mainly for the UFS device controller 2210. VCCQ may have a value of 1.14 to 1.26 V. VCCQ2 is a power supply voltage that supplies a voltage range lower than VCC but higher than VCCQ, mainly for input/output interfaces such as MIPI M-PHY 1251, and may have a value of 1.7 to 1.95 V. The above power voltages may be supplied to each component of the UFS device 2200 through a regulator 2260.

The regulator 2260 may be implemented as a set of unit regulators each connected to a different one of the aforementioned power supply voltages.

In some embodiments, each of the components represented by a block as illustrated in FIGS. 1, 2, 5, 6, 8, 12, 16 and 17 may be implemented as various numbers of hardware and/or firmware structures that execute respective functions described above, according to example embodiments. For example, at least one of these components may include various hardware components including a digital circuit, a programmable or non-programmable logic device or array, an application specific integrated circuit (ASIC), transistors, capacitors, logic gates, or other circuitry using use a direct circuit structure, such as a memory, a processor, a logic circuit, a look-up table, etc., that may execute the respective functions through controls of one or more microprocessors or other control apparatuses. Also, at least one of these components may further include or may be implemented by a processor such as a central processing unit (CPU) that performs the respective functions, a microprocessor, or the like. Functional aspects of example embodiments may be implemented in algorithms that execute on one or more processors. Furthermore, the components, elements, modules or units represented by a block or processing steps may employ any number of related art techniques for electronics configuration, signal processing and/or control, data processing and the like.

## Claims

1. A storage device comprising:
a first non-volatile memory device (31) comprising a first current management circuit (31_1) configured to receive a first command and first peak information in a first mode and determine an execution timing of the first command based on the first peak information, wherein the first non-volatile memory device (31) is configured to output first elapsed time information indicating an internal operation time according to the first command;
a second non-volatile memory device (33) comprising a second current management circuit (33_1) configured to receive a second command and the first peak information in the first mode and determine an execution timing of the second command based on the first peak information, wherein the second non-volatile memory device (33) is configured to output second elapsed time information indicating an internal operation time according to the second command, and
a storage controller (20) comprising a peak manager circuit (21) configured to output the first peak information and deactivate a failed current management circuit among the first current management circuit (31_1) and the second current management circuit (33_1) based on the first elapsed time information and the second elapsed time information.

2. The storage device of claim 1, wherein:
the first non-volatile memory device (31) comprises a plurality of memory blocks comprising a plurality of memory cells connected to a plurality of word lines, and
wherein the first non-volatile memory device (31) is further configured to isolate the plurality of word lines based on the first command.

3. The storage device of claim 2, wherein the first non-volatile memory device (31) comprises:
a voltage generator (620) configured to generate voltage signals for memory operation according to the first command;
a plurality of pass transistors (830) connected to the plurality of word lines and configured to transmit the voltage signals to the plurality of memory cells; and
a block decoder (820) configured to output a memory block select signal for selecting the plurality of memory blocks to gates of the plurality of pass transistors (830).

4. The storage device of claim 3, wherein the block decoder (820) is further configured to deactivate the memory block select signal based on the first command.

5. The storage device of any one of claims 1 to 4, wherein the first elapsed time information comprises time information indicating a time when the first non-volatile memory device (31) receives the first peak information and a time when the first non-volatile memory device (31) completes an internal operation according to the first command.

6. The storage device of any one of claims 1 to 5, wherein the first peak information has a first level (410) during a predetermined time and has a second level (420) outside of the predetermined time.

7. The storage device of claim 6, wherein the peak manager circuit (21) is further configured to identify a remaining time as a difference between a first elapsed time indicated by the first elapsed time information and the predetermined time, compare the remaining time with a reference time for a memory operation corresponding to the first command, and deactivate the first current management circuit (31_1) based on a difference between the remaining time and the reference time exceeding a threshold value.

8. The storage device of any one of claims 1 to 7, wherein:
the second non-volatile memory device (33) is further configured to receive a third command in a second mode different from the first mode,
the second current management circuit (33_1) is further configured to generate second peak information regarding the third command, and
the storage controller (20, 200, 500) further comprises a queue manager circuit (23) configured to perform a queue management operation for the first non-volatile memory device (31) based on the first current management circuit (31_1) being deactivated.

9. The storage device of claim 8, wherein the queue manager circuit (23) is further configured to assign a command having a low peak current to the first non-volatile memory device (31) based on the second peak information.

10. The storage device of claim 8 or 9, wherein the queue manager circuit (23) is further configured to queue a fourth command in a command queue based on the second peak information, determine an execution timing of the first non-volatile memory device (31) executing the fourth command based on the second peak information, and transmit the fourth command to the first non-volatile memory device (31) at the execution timing of the fourth command.

11. The storage device of any one of claims 8 to 10, further comprising a buffer memory (550) configured to store setting values of operating parameters corresponding to the first non-volatile memory device (31) and peak current values corresponding to the setting values of the operating parameters,
wherein the queue manager circuit (23) is further configured to change the setting values of the operating parameters corresponding to the first non-volatile memory device (31) based on the setting values of the operating parameters corresponding to the first non-volatile memory device (31) stored in the buffer memory (550) and the peak current values corresponding to the setting values of the operating parameters.

12. A storage controller (20, 200, 500), comprising:
a processor (510) configured to output a command for instructing a memory operation to a non-volatile memory device (31, 33, 600) comprising a plurality of memory cells, and output a dummy command for testing the performance of a current management circuit (31_1, 33_1, 651) within the non-volatile memory device (31, 33, 600) based on a signal representing an internal state of the non-volatile memory device (31, 33, 600);
a peak manager circuit (21) configured to output pseudo peak information indicating a peak current section based on the dummy command, receive elapsed time information indicating an internal operating time of the non-volatile memory device (31, 33, 600) according to the dummy command, and determine performance of the current management circuit (31_1, 33_1, 651) based on the elapsed time information; and
a queue manager circuit (23) configured to perform queue management operations for the non-volatile memory device (31, 33, 600) based on the performance of the current management circuit (31_1, 33_1, 651).

13. The storage controller (20, 200, 500) of claim 12, wherein the processor (510) is further configured to predict an operation completion time of the non-volatile memory device (31, 33, 600) according to the command, compare a first time at which the signal transitions from a first state to a second state different from the first state with the predicted operation completion time, and output the dummy command based on a difference between the first time and the predicted operation completion time exceeding a threshold value.

14. The storage controller of claim 12 or 13, further comprising a buffer memory (550) configured to store reference values for operating parameters of the non-volatile memory device (31, 33, 600),
wherein the storage controller (20, 200, 500) is configured to identify an internal operation time of the non-volatile memory device (31, 33, 600) for the dummy command based on the peak current section of the pseudo peak information and the elapsed time information, and determine the performance of the current management circuit (31_1, 33_1, 651) by comparing the internal operation time with a reference value for the operating parameters of the non-volatile memory device (31, 33, 600) .

15. The storage controller (20, 200, 500) of claim 14, wherein the operating parameters comprise a program time (tPROG) and a read time (tR).
